# FASCICULE DE BREVET EUROPEEN

(11) **EP 0 577 487 B1**
(45) Date de publication et mention de la délivrance du brevet: **10.09.1997**
(21) Numéro de dépôt: 93401655.1
(22) Date de dépôt: 28.06.1993
(51) Int. Cl.: H01L 31/115, H01L 27/146, H01L 27/148, H01L 25/04

(54) **Dispositif d'imagerie de rayonnements ionisants**
Bildaufnehmer für ionisierende Strahlung
Imager for ionising radiation

(30) Priorité: 30.06.1992 FR 9208029
(43) Date de publication de la demande: 05.01.1994
(73) Titulaire: COMMISSARIAT A L'ENERGIE ATOMIQUE, 75015 Paris (FR)
(72) Inventeur: Jeuch, Pierre, F-38180 Seyssins (FR); Cuzin, Marc, F-38700 Corenc (FR)
(74) Mandataire: Dubois-Chabert, Guy

(56) Documents cités:
- EP-A- 0 245 147
- EP-A- 0 415 541
- EP-A- 0 462 345
- EP-A- 0 485 115
- PATENT ABSTRACTS OF JAPAN vol. 6, no. 147 (E-123)(1025) 6 Août 1982
- NUCLEAR INSTRUMENTS & METHODS IN PHYSICS RESEARCH vol. A275, no. 3, 1 Mars 1989, AMSTERDAM NL pages 580 - 586 S. L. SHAPIRO ET AL. 'SILICON PIN DIODE ARRAY HYBRIDS FOR CHARGED PARTICLE DETECTION'

## Description

La présenté invention a pour objet un dispositif pour l'imagerie, soit d'un rayonnement ionisant tels que des rayonnements X, gamma ou de particules chargées, soit d'un rayonnement lumineux dont la longueur d'onde peut être située dans le domaine du visible de l'ultraviolet ou de l'infrarouge.

Plus spécialement, l'invention s'applique aux rayonnements ionisants non focalisables.

L'imagerie ou la prise d'images d'un rayonnement ionisant permet par projection radiographique ou reconstitution tomographique, l'étude de la matière vivante ou non et par conséquent une analyse non destructive de la structure interne d'objets de dimension et de masse variables notamment dans les domaines médicaux et nucléaires mais aussi dans l'industrie.

Ce dispositif peut être de grande dimension, quelques dizaines de cm² à quelques centaines de cm² de surface, principalement pour la mammographie ou de petite dimension, quelques centaines de mm², par exemple pour l'imagerie dentaire intra-buccale. Dans ce dernier cas, le dispositif peut présenter une épaisseur totale de 3 mm ; cette compacité est très importante pour ne pas gêner le patient ni le praticien.

Un dispositif d'imagerie comporte de façon connue une partie détectrice du rayonnement constituée d'un ou plusieurs détecteurs transformant le rayonnement incident en charges électriques et comportant des électrodes pour collecter ces charges et une partie traitement des signaux électriques résultant de la collection des charges, constituée de circuits intégrés pour amplifier ces signaux électriques et d'un dispositif extérieur de traitement et de mémorisation des signaux délivrés par ces circuits intégrés.

En outre, chaque détecteur est structuré en points élémentaires d'affichage ou pixels agencés selon les lignes et les colonnes d'une matrice.

Dans un premier type de détecteur, on utilise un matériau semi-conducteur équipé d'électrodes points réparties sous forme matricielle. Dans ce type de détecteur, la connexion électrique des circuits de lecture à chaque détecteur est assurée de façon connue par hybridation par microbilles, pixel par pixel.

Un tel système est notamment décrit dans le document M. Campbell et al. (A 10 MHz micro power CMOS front-end for direct readout of pixel detectors, IEEE Nuclear Science Symposium USA, 1989, p.1-8) et dans les documents EP-A-0 415 541 et EP-A-0 462 345.

Dans un autre type de détecteur, on utilise des dispositifs à transfert de charge (CCD) irradiés directement. L'irradiation de ces CCD provoque un vieillissement prématuré qui se traduit par une perte de sensibilité et des pixels défaillants.

En radiographie dentaire, le rayonnement X utilisé a une énergie élevée de 30 keV à 60 keV. En outre, le dispositif d'imagerie a une épaisseur faible généralement de 300 µm à 500 µm, ce qui lui confère un pouvoir d'arrêt des rayons X que de quelques pour cent (< à 10%). Il en résulte que 90% des photons X (et donc de la dose) sont imposés inutilement au patient, ce qui est un inconvénient majeur.

Pour la mammographie, on utilise des rayons X ayant une énergie de 15 keV à 25 keV.

Pour la réalisation de dispositifs d'imagerie de grande dimension, il est connu d'utiliser plusieurs matrices de détecteurs accolées bord à bord comme décrit dans le document EP-A-245 147 ou agencées comme les tuiles d'un toit comme décrit dans le document EP-A-421 869.

Dans le document EP-A-245 147, le détecteur est un scintillateur épais transformant le rayonnement ionisant en lumière visible, associée à une photodiode structurée en pixels.

Ces dispositifs d'imagerie conduisent en général à des images présentant des zones d'ombres et des pertes d'informations.

L'invention a pour objet un nouveau dispositif d'imagerie utilisant l'hybridation par microbilles des circuits de lecture, pixel par pixel, permettant notamnient de remédier à ces inconvenients.

De façon précise, l'invention a pour objet un dispositif d'imagerie d'un rayonnement comportant :
- des moyens de détection plans aptes à transformer le rayonnement en charges électriques et comportant une face d'entrée destinée à recevoir le rayonnement et une face de sortie opposée à la face d'entrée, la face d'entrée comportant une électrode commune et la face de sortie supportant une mosaïque d'électrodes points pour collecter les charges électriques ;
- des moyens pour recueillir les charges électriques collectées par les électrodes points, présentant une face plane pourvue de plots de contact électrique et disposée en regard de la face de sortie des moyens de détection, chaque plot de contact électrique étant en regard d'une électrode point correspondante et étant connecté à cette électrode point par une technique d'hybridation ;
caractérisé en ce que :
- les moyens de détection sont constitués par un détecteur ou plusieurs détecteurs accolés bord à bord ;
- les moyens pour recueillir les charges électriques sont constitués de puces de circuits intégrés accolées bord à bord, chaque puce comprenant une mosaïque de circuits de lecture, un circuit d'adressage connecté aux circuits de lecture de la puce, chaque plot de contact électrique étant relié à un circuit de lecture correspondant ;
- des bandes métalliques sont prévues sur la face plane des puces de circuits intégrés pour assurer des liaisons électriques entre les circuits de lecture et d'adressage et des circuits extérieurs d'alimentation, de commande et de traitement des signaux de sortie délivrés par les circuits intégrés ;
- des bandes métalliques sont réparties sur la face de sortie du détecteur (des détecteurs) sans contact électrique avec les électrodes points;
- les bandes métalliques des puces de circuits intégrés étant disposées en regard des bandes métalliques du détecteur (des détecteurs), la continuité de chaque liaison électrique étant assurée par l'intermédiaire de microbilles connectant de façon hybride les bandes métalliques correspondant à cette liaison et situées sur la face plane des puces aux bandes métalliques correspondant à cette liaison et situées sur la face de sortie du détecteur (des détecteurs).

De préférence, le détecteur consiste en un matériau semiconducteur massif revêtu sur une de ces faces de l'électrode commune et sur la face opposée des électrodes points. Ce matériau semiconducteur peut être réalisé en n'importe quel matériau semiconducteur connu tel que le germanium, le silicium, les alliages binaires, ternaires où quaternaires d'éléments III et V ou d'éléments II et VI de la classification périodique des éléments.

Afin d'obtenir un fort pouvoir d'arrêt des rayons X par le détecteur, et donc de diminuer la dose d'irradiation notamment dans le domaine médical, on utilise un matériau semiconducteur de numéro atomique moyen élevé, supérieur à 30. Le numéro atomique moyen est défini comme la somme des numéros atomiques des corps simples constituant le détecteur divisée par le nombre d'atomes du matériau (par exemple pour CdTe, z moyen = 50). Ainsi, pour un détecteur en CdTe de 800 µm, 99% d'un rayonnement X de 40 keV sont arrêtés et la dose imposée au patient peut être réduite d'un facteur 10.

De plus, la bande d'énergie interdite doit être aussi élevée que possible, supérieur à 1,30 eV.

Ce semiconducteur est en particulier du silicium, du GaAs ou mieux du CdTe ou du HgI₂ de haute résistivité électrique (par exemple 10⁹ ohms.cm pour CdTe).

L'utilisation d'un semiconducteur massif homogène de haute résistivité permet de limiter le courant de fuite entre l'électrode commune et les électrodes points. De plus, l'emploi d'un semiconducteur améliore la qualité spatiale de l'image et son contraste par rapport à l'emploi d'un scintillateur puisqu'un photon crée des charges dans un faible volume de semiconducteur (quelques µm³ pour un photon X de 40 keV), alors que l'information peut diffuser latéralement dans le scintillateur. Ceci permet la réalisation d'un détecteur de forte épaisseur (500 à 1000 µm), améliorant son pouvoir d'arrêt du rayonnement.

Par ailleurs, le rendement d'un semiconducteur est supérieur à celui d'un scintillateur et peut aller jusqu'à 50%, et sa sensibilité est améliorée. Ainsi, des microcalcifications inférieures à 100 µm peuvent être détectées dans un sein.

Il est toutefois possible d'utiliser une jonction PN ou encore un contact Schottky redresseur. Par ailleurs, le détecteur peut être un scintillateur convertissant le rayonnement ionisant en lumière visible, recouvrant une photodiode structurée en points élémentaires d'affichage et assurant la transformation de la lumière en un signal électrique.

Pour la réalisation d'un dispositif d'imagerie de grande dimension, on utilise plusieurs détecteurs accolés bord à bord et disposés sous forme d'une matrice, ces détecteurs étant connectés entre eux et associés à plusieurs puces de circuits intégrés accolées bord à bord, connectées entre elles et agencées aussi sous forme d'une matrice.

Les puces de circuits intégrés ont les mêmes dimensions que les détecteurs ou des dimensions égales à un multiple ou un à sous-multiple entier des dimensions de ces détecteurs.

De façon avantageuse, les puces de circuits intégrés sont décalées par rapport aux détecteurs selon une ou deux directions perpendiculaires contenues dans un plan parallèle à celui des détecteurs, de façon à être partiellement en regard de deux ou quatre détecteurs adjacents.

De façon avantageuse, la liaison électrique entre deux détecteurs consécutifs est assurée par une bande métallique formée sur la puce de circuits intégrés partiellement en regard de ces deux détecteurs consécutifs et par des microbilles.

De façon avantageuse, la liaison électrique entre deux puces consécutives est assurée par une bande métallique formée sur le détecteur partiellement en regard de ces deux puces consécutives et par des microbilles.

Dans une variante de réalisation, les liaisons électriques inter-détecteurs et les liaisons électriques inter-circuits intégrés peuvent être décalées respectivement d'une colonne ou d'une ligne à l'autre. Ceci permet une connexion latérale du dispositif de l'invention aux circuits extérieurs d'alimentation, de commande et de traitement de signaux.

Dans le cas de n puces agencées selon une même ligne de la matrice de puces et de n bandes métalliques spécifiques numérotées de 1 à n pour véhiculer vers un même côté du dispositif les signaux de sortie spécifiques de ces n puces, ces bandes comportant, par rapport à ce même côté du dispositif, une entrée et une sortie, l'extrémité de sortie de la i^{ième} bande d'une puce déterminée est reliée à l'extrémité d'entrée de la (i+1)^{ième} bande de la puce suivante, avec 1≤i≤n, i et n étant des entiers avec n≥2; grâce à une bande métallique supplémentaire prévue sur la face de sortie du détecteur placée en regard de ces puces et grâce à des microbilles assurant une connexion de façon hybride entre bande métallique spécifique de puce et bande métallique supplémentaire de détecteur, la première bande d'une puce déterminée délivrant le signal de sortie spécifique de ladite puce déterminée.

D'autres caractéristiques et avantages de l'invention ressortiront mieux à la description qui va suivre, donnée à titre illustratif et non limitatif, en référence aux figures annexées, dans lesquelles :
- les figures 1a et 1b représentent schématiquement, en coupe longitudinale et en vue de dessus selon le plan B-B de la figure 1a, un dispositif d'imagerie conforme à l'invention,
- la figure 1c représente le schéma électrique équivalent d'un ensemble détecteur-puce du dispositif de l'invention,
- la figure 2 représente de façon agrandie selon une première variante les connexions entre un détecteur et la puce de circuit intégré associée, conformément à l'invention,
- la figure 3 illustre une variante de réalisation du dispositif de l'invention,
- les figures 4 et 5 représentent schématiquement en coupe des variantes de réalisation des connexions entre le détecteur et la puce de circuit intégré associée,
- la figure 6 représente schématiquement un mode de réalisation des connexions respectivement entre les puces et les détecteurs conformément à l'invention.

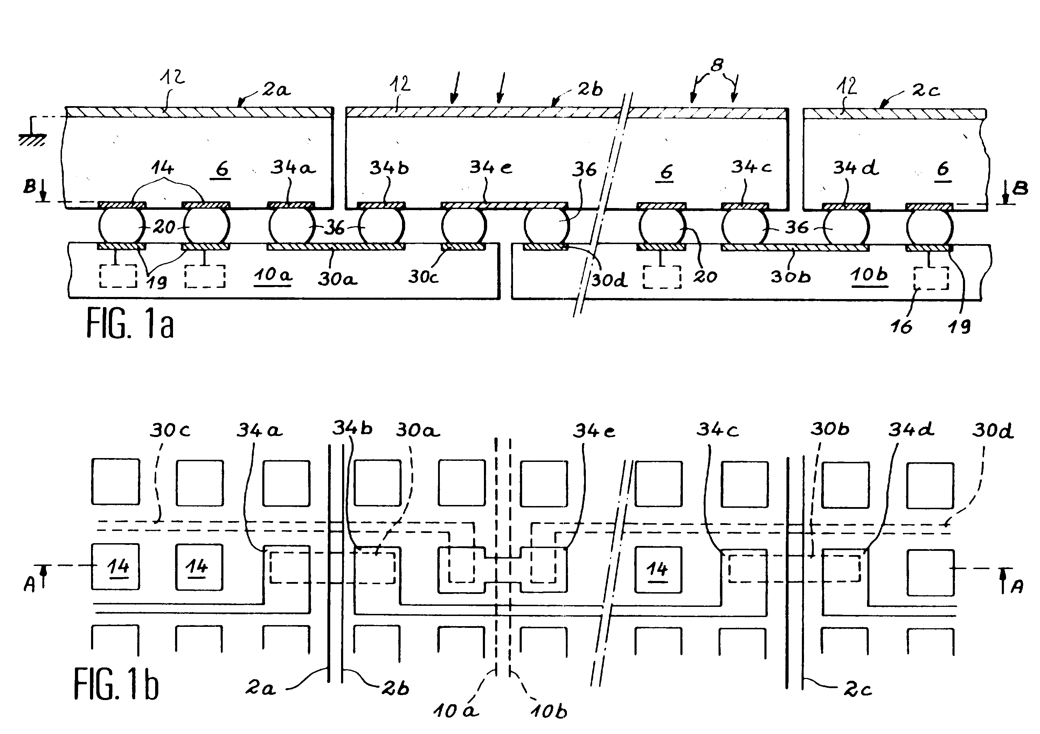

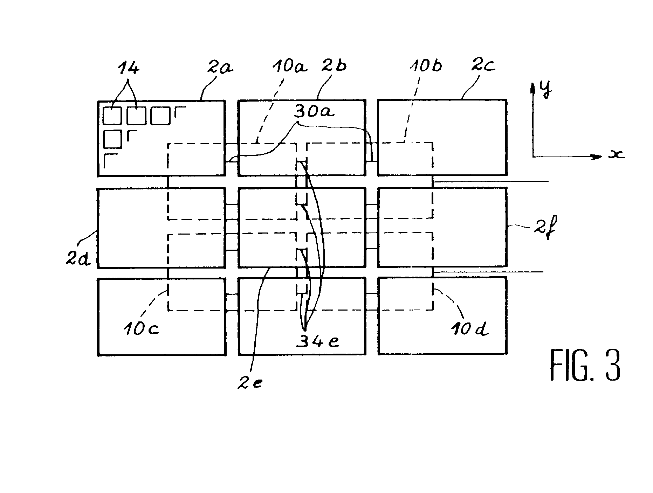

Le dispositif d'imagerie conforme à l'invention, représenté sur les figures 1a, 1b et 3 comporte plusieurs détecteurs plans 2a, 2b, 2c, 2d, 2e, 2f disposés bord à bord de façon à former une matrice de détecteurs comportant des lignes et des colonnes.

Ces détecteurs comportent chacun un matériau solide semi-conducteur 6 homogène et de haute résistivité par exemple en silicium, GaAs, CdTe ou HgI₂ comportant une face d'entrée destinée à recevoir un rayonnement ionisant 8 et une face de sortie opposée à la face d'entrée disposée en regard de puces 10a, 10b, 10c, 10d de circuits intégrés, réalisées sur silicium. Le rayonnement 8 provient par exemple d'un objet à analyser irradié.

La face d'entrée de chaque détecteur 2a-2f comporte une électrode commune 12 la recouvrant totalement alors que la face de sortie supporte des électrodes points 14 agencées selon une mosaïque. Ainsi, chaque détecteur 2a-2f est structuré par sa face de sortie en points élémentaires d'images ou pixels. Les électrodes communes 12 et points 14 sont réalisées en métal tel que l'aluminium de 1 µm d'épaisseur.

Lorsqu'un détecteur semi-conducteur reçoit un rayonnement ionisant 8, il engendre des paires électrons trous dans le semi-conducteur 6 qui sont collectées par les électrodes 12 et 14.

L'épaisseur du semiconducteur 6 dépend du matériau utilisé, de l'énergie des rayonnements à détecter et de l'application envisagée. Par exemple on utilise une épaisseur de 500 µm pour détecter des rayons X de quelques dizaines de KeV avec du CdTe. De même, les dimensions surfaciques des électrodes points, et donc des pixels, dépendent de l'application recherchée.

Typiquement en radiographie, tomographie ou mammographie, ces électrodes points ont des dimensions de 100x100µm² ou 80x80µm² et sont séparées d'une distance de 20µm.

Les puces 10a-10d de circuits intégrés comportent chacune une mosaïque de circuits de lecture 16 formant des lignes et des colonnes.

Le nombre de puces de circuits intégrés est égal au nombre de détecteurs et ce nombre dépend de l'application envisagée. De plus, les dimensions des puces et des détecteurs dans le plan xy parallèle aux faces de sortie des détecteurs sont identiques.

En particulier chaque détecteur et chaque puce comporte dans le plan xy une surface de 1,5x1,5cm². En outre, les dimensions des électrodes points 14 dans le plan xy sont identiques à celles des circuits de lecture 16.

La connexion entre chaque électrode point 14 et entre le plot de contact 19 de chaque circuit de lecture 16 est assurée par une bille d'indium 20.

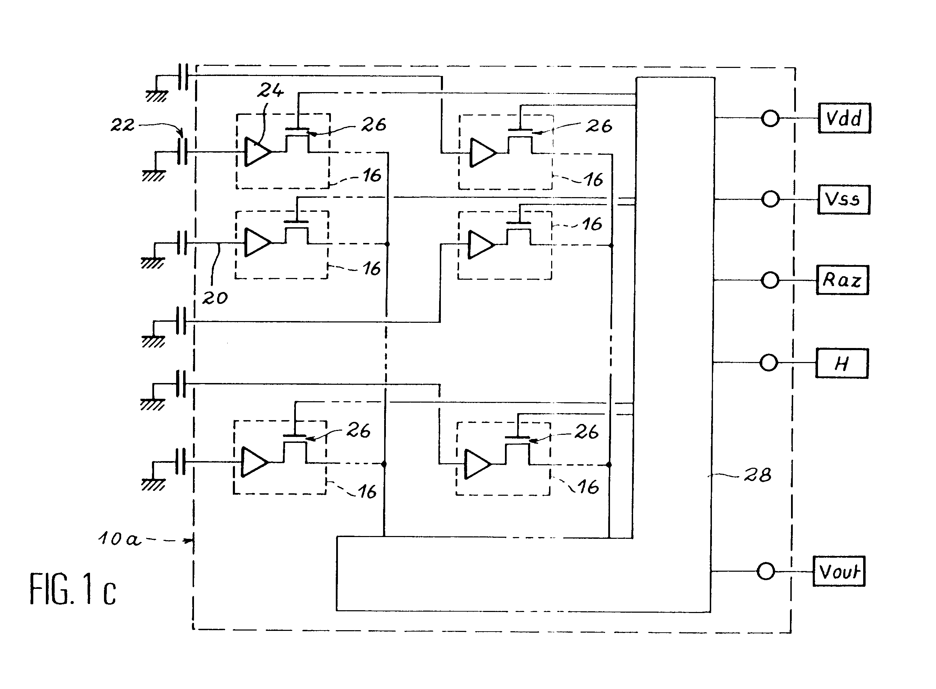

Sur la figure 1c on a représenté le schéma électrique équivalent d'un ensemble détecteur-puce de l'invention montrant notamment les connexions extérieures d'alimentation, de commande et de sortie.

Chaque pixel d'un détecteur est représenté par un condensateur 22 dont les armatures sont les électrodes 12 et 14, l'électrode 12 étant portée au potentiel de la masse. Ce condensateur 22 est connecté via une bille d'indium 20 à un amplificateur 24 puis à un commutateur 26 du type transistor MOS de lecture du pixel.

Ces commutateurs 26 sont activés les uns après les autres via des lignes et des colonnes d'adressage par le circuit 28 d'adressage séquentiel (appelé circuit scrutateur). Ce circuit 28 adresse donc chaque pixel de détection les uns après les autres en engendrant leur adresse à partir d'une horloge externe H.

Le circuit d'adressage 28 est aussi relié à une source externe d'alimentation électrique délivrant une tension d'alimentation Vdd par rapport à la masse ou tension fixe de référence Vss. En outre ce circuit 28 est relié à un circuit externe d'initialisation de lecture délivrant un signal R_{az} .

Par ailleurs chaque transistor 26 délivre après son adressage un signal de sortie Vₒᵤₜ spécifique du rayonnement ionisant 8 ayant frappé le pixel correspondant.

Le signal vidéo engendré (ou succession des signaux Vₒᵤₜ est traité dans un dispositif extérieur de traitement et de mémorisation des informations, du type micro-processeur.

L'objet de l'invention ne concerne pas la fonctionalité ou la disposition de ces différents composants 24, 26 et 28 dans chaque puce mais la façon de connecter ces puces aux signaux d'alimentation Vdd, d'horloge H, d'initialisation de lecture R_{az}, ainsi que la connexion à la masse de ces puces, via les détecteurs servant de support de connexion.

L'invention porte aussi sur la façon de connecter la sortie spécifique Vₒᵤₜ de chaque puce au circuit de traitement et de mémorisation externe.

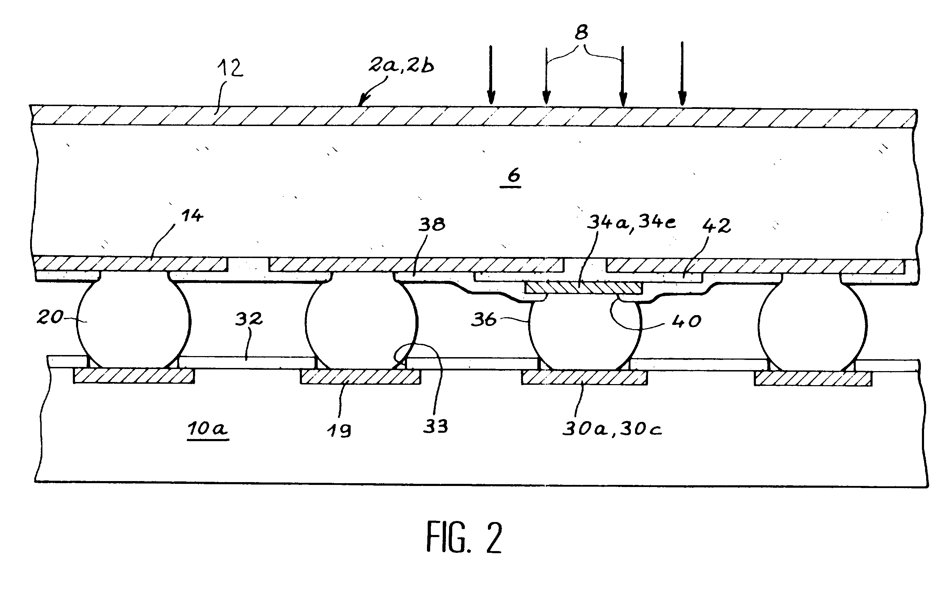

Pour connecter chaque puce 10a-10d à l'extérieur respectivement à la source d'alimentation électrique, à la masse, au circuit d'initialisation, à l'horloge et au dispositif de traitement, l'invention propose la réalisation de bandes métalliques 30a, 30b, 30c, 30d supplémentaires à la surface de chaque puce comme représenté sur les figures 1a, 1b et 2. Sur la figure 2 la référence 32 représente la couche de passivation finale en silice de la puce qui comporte, par rapport à l'art antérieur, des ouvertures 33 en regard des métallisations supplémentaires 30a-30d des puces.

De même, les faces de sortie de chaque détecteurs 2a-2f comportent des bandes métalliques supplémentaires 34a, 34b, 34c, 34d, 34e faisant face aux bandes métalliques 30a-30d des puces. Comme pour les métallisations 30a-30d des puces, les métallisations 34a-34e des détecteurs sont recouvertes d'une couche de passivation 38 en silice équipée d'ouvertures 40 en regard des métallisations 34a-34e.

Les métallisations 30a-30d et 34a-34e sont réalisées par exemple en aluminium sur 1 µm d'épaisseur.

Conformément à l'invention, la connexion de ces bandes 30a-30d avec les bandes 34a-34e est assurée à l'aide de microbilles 36 d'indium comme la connexion des électrodes points 14 aux plots de contact 19 des transistors 24 des circuits de lecture.

Selon une première variante de réalisation, représentée sur la figure 2, les métallisations 34a-34e formées sur chaque détecteur sont isolées électriquement des électrodes points 14 par des bandes isolantes 42 de dimensions surfaciques supérieures à celles des métallisations 34a-34e. Ces bandes isolantes 42 sont en particulier en polyimide de 5 µm d'épaisseur.

Comme représenté sur les figures 1a et 1b, et selon l'invention, les puces 10a-10d sont décalées par rapport aux détecteurs d'environ un pas selon une direction par exemple x ou comme représenté sur la figure 3 selon deux directions xy. Ainsi, chaque puce se trouve partiellement en regard de deux ou quatre détecteurs ; par exemple la puce 10a est en regard des détecteurs 2a, 2b (figures 1a-1b) et éventuellement aussi en regard des détecteurs 2d, 2e (figure 3).

Conformément à l'invention les détecteurs 2a-2f sont reliés électriquement entre eux par des liaisons électriques connectées aux métallisations 34a-34d et les puces 10a-10d sont reliées électriquement entre elles par des liaisons électriques connectées aux métallisations 30c, 30d de sorte que les signaux d'entrée (Vdd, Vss, R_{az}, H) sont appliqués latéralement sur l'ensemble du dispositif d'imagerie et que les signaux de sortie Vₒᵤₜ sont aussi récupérés sur l'un des côtés du dispositif d'imagerie.

Selon l'invention les liaisons électriques entre deux détecteurs consécutifs sont constituées des métallisations formées sur la puce disposée en regard des bords de ces deux détecteurs à connecter (voir figure 1b), et des microbilles 36 connectant les métallisations de cette puce aux métallisations de ces détecteurs.

Par exemple la métallisation 30a de la puce 10a est connectée aux métallisations périphériques 34a et 34b respectivement des détecteurs 2a et 2b, via les billes 36 en regard, assurant ainsi l'interconnexion de ces deux détecteurs. De même, la métallisation 30b de la puce 10b est connectée aux métallisations périphériques 34c et 34d respectivement des détecteurs 2b et 2c via les billes 36 en regard, assurant ainsi l'interconnexion de ces deux détecteurs.

Parallèlement les liaisons entre deux puces consécutives sont réalisées à l'aide des métallisations formées sur le détecteur en regard des bords respectivement des deux puces à connecter et des microbilles 36 en regard de ces métallisations. Par exemple (figure 1b) la métallisation 34e du détecteur 2b assure la connexion des métallisations 30c et 30d, respectivement des puces 10a et 10b via les billes d'indium 36 en regard et donc l'interconnexion des puces 10a et 10b.

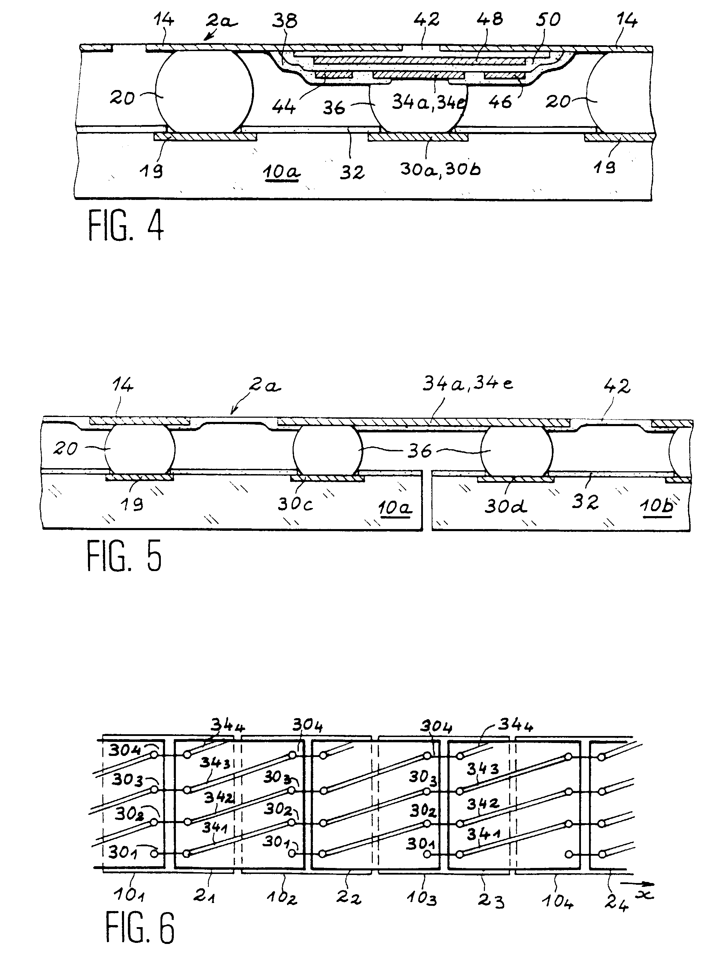

Sur la figure 4 on a représenté une variante de réalisation des métallisations 34a-34e de la face de sortie des détecteurs permettant en particulier de découpler les électrodes points 14 de ces métallisations. A cet effet, on utilise de part et d'autre de chaque métallisation 34a, 34e deux bandes conductrices 44 et 46 et une métallisation 48 interposée entre l'isolant d'électrodes 42 et les métallisations 34a, 34e, 44 et 46. La bande de métallisation 48 est en outre isolée des métallisations 34a, 34e, 44 et 46 par un isolant 50 par exemple en polyimide.

Les métallisations 44 et 46 sont réalisées en même temps que les métallisations 34a, 34e dans une même couche d'aluminium. La couche 48 est formée par gravure d'une couche d'aluminium de 1um d'épaisseur et sert d'écran entre les électrodes points 14 et les métallisations 34a, 34e. Pour compléter cet effet d'écran latéral, les métallisations 44 et 46 sont reliées à la masse ou à un potentiel fixe.

Sur la figure 5 on a représenté une autre variante de réalisation des métallisations de la face de sortie des détecteurs pour assurer leur interconnexion. Dans cette variante les métallisations telles que 34a, 34e consistent en des électrodes points. Cette solution à l'inconvénient de supprimer des électrodes points aux emplacements destinés aux métallisations d'interconnexions des détecteurs et des puces. En revanche, cette solution est beaucoup plus simple à réaliser que celle représentée sur les figures 2 et 4.

Les signaux d'alimentation Vdd, la masse Vss, les signaux d'initialisation de lecture R_{az} et d'horloge H sont envoyés simultanément et en parallèle sur toutes les puces 10a-10d. Ces signaux sont donc appliqués a des connexions communes à toutes les puces. En revanche, le signal de sortie Vₒᵤₜ est spécifique à chaque puce 10a-10d.

En vue d'une radiographie, il est nécessaire d'individualiser les signaux Vₒᵤₜ délivrés par chaque puce. Pour ce faire, il est possible de personnaliser chaque puce de façon que le signal Vₒᵤₜ sorte à un endroit différent d'une puce à une autre. Ceci oblige une personnalisation de chaque puce au moment de la fabrication ce qui est contraire à la fabrication en série et complique quelques peu le dispositif d'imagerie.

Aussi, pour que les signaux de sortie Vₒᵤₜ des différentes puces du dispositif sortent toutes du même coté du dispositif en parallèle, l'invention propose une connexion originale des différentes sorties comme représentée sur la figure 6.

Sur cette figure on a représenté quatre puces (n=4) 10₁, 10₂, 10₃, 10₄ d'une même ligne de la matrice de puces, décalées selon la direction x par rapport à des détecteurs 2₁, 2₂, 2₃, 2₄ d'une même ligne de la matrice de détecteurs. Chaque puce 10ᵢ (avec i allant de 1 à 4) comporte quatre métallisations supplémentaires 30₁, 30₂, 30₃, et 30₄ (représentées en trait fin). De même chaque détecteur 2 comporte des métallisations supplémentaires 34₁, 34₂, 34₃, 34₄ représentées sous forme de bandes.

Conformément à l'invention, l'extrémité de sortie de la métallisation 30ᵢ de chaque puce 10ᵢ est connectée à l'extrémité d'entrée de la métallisation 30ᵢ₊₁ de la puce suivante 10ᵢ₊₁, via la métallisation 34ᵢ formée sur le détecteur 2ᵢ, en regard respectivement des deux puces successives 10ᵢ et 10ᵢ₊₁, la connexion étant assurée comme précédemment à l'aide de microbilles.

Ainsi, l'extrémité de sortie de la métallisation 30₂ de la puce 10₁ par exemple est connectée à l'extrémité d'entrée de la métallisation 30₃ de la puce 10₂ via la métallisation 34₂ formée sur le détecteur 2₁ en regard des puces 10₁ et 10₂ et à l'aide des microbilles en regard de ces métallisations.

Ainsi, la sortie 30₄ de la puce 10₄ fournit le signal Vₒᵤₜ issu de la puce 10₁. De même, la sortie de la métallisation 30₃ de la puce 10₄ produit le signal Vₒᵤₜ issu de la puce 10₂ et la sortie de la métallisation 30₁ de la puce 10₄ fournit la signal Vₒᵤₜ issu de la puce 10₄.

Cette méthode de connexion permet la réalisation de puces identiques avec leur trou de contact délivrant la tension Vₒᵤₜ au même endroit facilitant ainsi leur fabrication. Cette individualisation des signaux de sortie est possible grâce à la technique de microbrilles, de décalage d'un pas des détecteurs par rapport aux puces et de l'utilisation respectivement des détecteurs comme support de métallisations entre les puces pour leur connexion, via les microbilles, et des puces comme support de métallisations entre les détecteurs pour leur connexion, via les microbilles.

Au lieu de réaliser les métallisations 30ᵢ des puces selon la direction x et de réaliser les métallisations 34ᵢ des détecteurs de façon oblique (figure 6), il est possible de réaliser les métallisations 34ᵢ parallèlement à la direction x et d'orienter dans ce cas, les métallisations 30ᵢ des puces en oblique.

Dans le cas d'un dispositif d'imagerie dentaire intra-buccale, l'ensemble détecteurs-puces de circuits intégrés peut être logé dans un boîtier étanche, électriquement isolant comportant une fenêtre en matériau transparent aux rayons X.

## Revendications

1. Dispositif d'imagerie d'un rayonnement (8) comportant :
- des moyens de détection plans (2a-2f) aptes à transformer le rayonnement en charges électriques et comportant une face d'entrée destinée à recevoir le rayonnement et une face de sortie opposée à la face d'entrée, la face d'entrée comportant une électrode commune (12) et la face de sortie supportant une mosaïque d'électrodes points (14) pour collecter les charges électriques ;
- des moyens (10a-10d) pour recueillir les charges électriques collectées par les électrodes points (14), présentant une face plane pourvue de plots de contact électrique (19) et disposée en regard de la face de sortie des moyens de détection, chaque plot de contact électrique (19) étant en regard d'une électrode point (14) correspondante et étant connecté à cette électrode point par une technique d'hybridation ;
caractérisé en ce que :
- les moyens de détection sont constitués par un détecteur ou plusieurs détecteurs (2a-2f) accolés bord à bord ;
- les moyens pour recueillir les charges électriques sont constitués de puces de circuits intégrés (10a-10d) accolées bord à bord, chaque puce comprenant une mosaïque de circuits de lecture (16), un circuit d'adressage (28) connecté aux circuits de lecture de la puce, chaque plot de contact électrique (19) étant relié à un circuit de lecture (16) correspondant ;
- des bandes métalliques (30a-30d) sont prévues sur la face plane des puces de circuits intégrés pour assurer des liaisons électriques entre les circuits de lecture et d'adressage et des circuits extérieurs d'alimentation, de commande et de traitement des signaux de sortie délivrés par les circuits intégrés ;
- des bandes métalliques (34a-34e) sont réparties sur la face de sortie du détecteur (des détecteurs) (2a-2f) sans contact électrique avec les électrodes points (14);
- les bandes métalliques (30a-30d) des puces de circuits intégrés étant disposées en regard des bandes métalliques du détecteur (des détecteurs), la continuité de chaque liaison électrique étant assurée par l'intermédiaire de microbilles (36) connectant de façon hybride les bandes métalliques (30a-30d) correspondant à cette liaison et situées sur la face plane des puces (10a-10d) aux bandes métalliques (34a-34e) correspondant à cette liaison et situées sur la face de sortie du détecteur (des détecteurs) (2a-2f).

2. Dispositif selon la revendication 1, caractérisé en ce qu'une couche d'isolant électrique (42) sépare chaque bande métallique (34a) sur la face de sortie des moyens de détection (2a) des électrodes points (14) voisines.

3. Dispositif selon l'une des revendications 1 ou 2, caractérisé en ce que le(s) détecteur(s) apte(s) à transformer le rayonnement en charges électriques consiste(nt) en un matériau semiconducteur massif (6).

4. Dispositif selon la revendication 2, caractérisé en ce qu'une bande de métallisation (48) servant d'écran entre ces bandes métalliques (34a) et les électrodes points (14) est interposée entre la couche d'isolant électrique (42) et les bandes métalliques (34) et est isolée des bandes métalliques (34) par un isolant (50).

5. Dispositif selon l'une quelconque des revendications précédentes, caractérisé en ce qu'il comporte plusieurs détecteurs (2a-2f) accolés bord à bord, disposés sous forme de lignes et de colonnes d'une première matrice et plusieurs puces de circuits intégrés (10a-10d) accolées bord à bord et disposées sous forme de lignes et de colonnes d'une seconde matrice faisant face à la première.

6. Dispositif selon l'une quelconque des revendications 1 à 5, caractérisé en ce que les dimensions des puces sont les mêmes que celles du ou des détecteurs.

7. Dispositif selon la revendication 5 ou 6, caractérisé en ce que les puces (10ᵢ) de circuits intégrés sont décalées de façon à être partiellement en regard d'au moins deux détecteurs consécutifs (2ᵢ, 2ᵢ₊₁).

8. Dispositif selon la revendication 7, caractérisé en ce que chaque liaison électrique entre deux puces consécutives est assurée par une bande métallique (34e, 34i) formée sur le détecteur partiellement en regard des bords de ces deux puces consécutives et par des microbilles (36), connectant les bandes métalliques (30a-30d) des puces à la bande métallique (34e, 34i) du détecteur.

9. Dispositif selon la revendication 7 ou 8, caractérisé en ce que chaque liaison électrique entre les bandes métalliques (34a-d, 34i) de deux détecteurs consécutifs est assurée par une bande métallique (30a-30d, 30i) formée sur la puce de circuits intégrés partiellement en regard de ces deux détecteurs consécutifs et par des microbilles (36).

10. Dispositif selon la revendication 7, caractérisé en ce qu'il comporte n puces (10₁-10₄) sur une même ligne de la seconde matrice et n bandes métalliques (30ᵢ) spécifiques sur la face plane présentée par chaque puce et numérotées de 1 à n pour véhiculer vers un même côté du dispositif les signaux de sortie spécifiques (Vₒᵤₜ) de ces n puces, ces bandes métalliques comportant, par rapport à ce même côté du dispositif, une entrée et une sortie, l'extrémité de sortie de la i^{ième} bande métallique d'une puce déterminée étant reliée à l'extrémité d'entrée de la (i+1)^{ième} bande métallique de la puce suivante, avec 1≤i≤n, i et n étant des entiers avec n≥2, grâce à une bande métallique supplémentaire (34₁-34₄) prévue sur la face de sortie du détecteur (2₁-2₄) placée en regard de ces puces et grâce à des microbilles assurant une connexion de façon hybride entre bande métallique spécifique de puce et bande métallique supplémentaire de détecteur, la première bande métallique d'une puce déterminée délivrant le signal de sortie spécifique de ladite puce.

11. Dispositif selon la revendication 3, caractérisé en ce que le matériau semiconducteur présente un numéro atomique moyen supérieur à 30.

12. Dispositif selon la revendication 3, caractérisé en ce que le matériau semiconducteur est choisi parmi le silicium, l'arséniure de gallium, le tellurure de cadmium ou l'iodure mercurique de haute résistivité.

13. Application du dispositif d'imagerie selon l'une quelconque des revendications 1 à 12 dans un appareil d'imagerie dentaire intra-buccale utilisant un rayonnement X.

14. Application du dispositif d'imagerie selon l'une quelconque des revendications 1 à 12 dans un appareil de mammographie utilisant un rayonnement X.

## Patentansprüche

1. Bildaufnehmer einer Strahlung (8), umfassend:
- flache Detektionseinrichtungen (2a-2f), fähig die Strahlung in elektrische Ladung umzuwandeln, eine Eintrittsseite zur Aufnahme der Strahlung und eine der Eintrittsseite entgegengesetzte Austrittsseite umfassend, wobei die Eintrittsseite eine gemeinsame Elektrode (12) aufweist und die Austrittsseite ein Mosaik aus Punktelektroden (14) trägt, um die elektrischen Ladungen zu sammeln;
- Einrichtungen (10a-10d) zum Aufnehmen der durch die Punktelektroden (14) gesammelten elektrischen Ladungen, eine ebene, mit elektrischen Kontaktstellen (19) versehene Fläche bzw. Seite aufweisend, der Austrittsseite der Detektionseinrichtungen gegenüberstehend, wobei jede elektrische Kontaktstelle (19) einer entsprechenden Punktelektrode (14) gegenübersteht und mit dieser Punktelektrode durch eine Hybridisierungstechnik verbunden ist;
**dadurch gekennzeichnet** :
- daß die Detektionseinrichtungen gebildet werden durch einen Detektor oder mehrere Rand an Rand zusammengesetzte Detektoren (2a-2f),
- daß die Einrichtungen zum Aufnehmen der elektrischen Ladungen durch IC-Chips (10a-10d) gebildet werden, wobei jeder Chip ein Mosaik aus Leseschaltungen (16) und eine mit den Leseschaltungen verbundene Adressierschaltung (28) umfaßt und jede elektrische Kontaktstelle (19) mit einer entsprechenden Leseschaltung (16) verbunden ist;
- daß metallische Streifen (30a-30d) auf der ebenen Fläche bzw. Seite der IC-Chips vorgesehen sind, um elektrische Verbindungen zwischen den Lese- und Adressierschaltungen und externen Versorgungs-, Steuer- und Verarbeitungsschaltungen der durch die integrierten Schaltungen gelieferten Ausgangssignale sicherzustellen;
- daß metallische Streifen (34a-34e) verteilt sind auf der Austrittsseite des Detektors (der Detektoren) (2a-2f) ohne elektrischen Kontakt mit den Punktelektroden (14);
- daß die metallischen Streifen (30a-30d) der IC-Chips den metallischen Streifen des Detektors (der Detektoren) gegenüberstehend angeordnet sind, wobei die Kontinuität jeder elektrischen Verbindung über Mikrokugeln (36) sichergestellt ist, die in hybrider Weise die dieser Verbindung entsprechenden und auf der planen bzw. ebenen Seite der Chips (10a-10d) befindlichen metallischen Streifen (30a-30d) verbinden mit den dieser Verbindung entsprechenden und auf der Austrittsseite des Detektors (der Detektoren) (2a-2f) befindlichen metallischen Streifen (34a-34e).

2. Bildaufnehmer nach Anspruch 1, dadurch gekennzeichnet, daß eine elektrische Isolierschicht (42) jeden metallischen Streifen (34a) auf der Austrittsseite der Detektionseinrichtungen (2a) von den benachbarten Punktelektroden (14) trennt.

3. Bildaufnehmer nach einem der Ansprüche 1 oder 2, dadurch gekennzeichnet, daß der (die) Detektor(en), befähigt die Strahlung in elektrische Ladungen umzuwandeln, aus einem massiven Halbleitermaterial besteht (bestehen).

4. Bildaufnehmer nach Anspruch 2, dadurch gekennzeichnet, daß ein als Abschirmung zwischen diesen metallischen Streifen (34a) und den Punktelektroden (14) dienender Metallisationsstreifen (48) eingefügt wird zwischen die elektrische Isolierschicht (42) und die metallischen Streifen (34) und von den metallischen Streifen (34) isoliert wird durch ein Isoliermaterial (50).

5. Bildaufnehmer nach einem der vorangehenden Ansprüche, dadurch gekennzeichnet, daß es mehrere Rand an Rand zusammengesetzte Detektoren (2a-2f) umfaßt, angeordnet in Form von Zeilen und Spalten einer ersten Matrix, und mehrere IC-Chips (10a-10d), Rand an Rand zusammengesetzt und Zeilen und Spalten einer zweiten, der ersten gegenüberstehenden Matrix bildend.

6. Bildaufnehmer nach einem der Ansprüche 1 bis 5, dadurch gekennzeichnet, daß die Abmessungen der Chips dieselben sind wie die des Detektors oder der Detektoren.

7. Bildaufnehmer nach Anspruch 5 oder 6, dadurch gekennzeichnet, daß die IC-Chips (10ᵢ) derart versetzt sind, daß sie wenigstens zwei aufeinanderfolgenden Detektoren (2ᵢ,2ᵢ₊₁) partiell gegenüberstehen.

8. Bildaufnehmer nach Anspruch 7, dadurch gekennzeichnet, daß jede elektrische Verbindung zwischen zwei aufeinanderfolgenden Chips sichergestellt wird durch einen metallischen Streifen (34e, 34i), ausgebildet auf dem Detektor, den Rändern dieser beiden aufeinanderfolgenden Chips partiell gegenüberstehend, und durch Mikrokugeln (36), welche die metallischen Streifen (30a-30d) der Chips mit dem metallischen Streifen (34e, 34i) des Detektors verbinden.

9. Bildaufnehmer nach Anspruch 7 oder 8, dadurch gekennzeichnet, daß jede elektrische Verbindung zwischen den metallischen Streifen (34a-d, 34i) von zwei aufeinanderfolgenden Detektoren sichergestellt wird durch einen metallischen Streifen (30a-30d, 30i), ausgebildet auf dem IC-Chip, diesen beiden aufeinanderfolgenden Detektoren partiell gegenüberstehend, und durch Mikrokugeln (36).

10. Bildaufnehmer nach Anspruch 7, dadurch gekennzeichnet, daß er n Chips (10₁-10₄) in ein und derselben Zeile der zweiten Matrix umfaßt und n spezifische Metallstreifen (30ᵢ) auf der ebenen Fläche jedes der von 1 bis n numerierten Chips, um die spezifischen Ausgangssignale (Vₒᵤₜ) dieser n Chips nach einer bzw. derselben Seite des Bildaufnehmers zu leiten, wobei diese Metallstreifen in bezug auf eben diese Seite des Bildaufnehmers einen Eingang und einen Ausgang umfassen und das Ausgangsende des 1.Metallstreifens eines bestimmten Chips mit dem Eingangsende des (i+l).Metallstreifens des nachfolgenden Chips, mit 1<i<n, wobei i und n ganze Zahlen sind mit n≥2, verbunden ist dank eines zusätzlichen Metallstreifens (34₁-34₄), vorgesehen auf der Austrittsseite des Detektors (21-24), diesen Chips gegenüberstehend, und dank Mikrokugeln, die eine Verbindung der hybriden Art herstellen zwischen spezifischem Chip-Metallstreifen und zusätzlichem Detektor-Metallstreifen.

11. Bildaufnehmer nach Anspruch 3, dadurch gekennzeichnet, daß das Halbleitermaterial eine mittlere Atomnummer bzw. Ordnungszahl höher als 30 aufweist.

12. Bildaufnehmer nach Anspruch 3, dadurch gekennzeichnet, daß das Halbleitermaterial ausgewählt wird unter Silicium, Galliumarsenid, Cadmiumtellurid oder Quecksilber(II)-Iodid von hoher Resistivität.

13. Anwendung des Bildaufnehmers nach einem der Ansprüche 1 bis 12 in einem in die Mundhöhle einführbaren, eine Röntgenstrahlung benutzenden Zahnbildaufnahme-Apparat.

14. Anwendung des Bildaufnehmers nach einem der Ansprüche 1 bis 12 in einem eine Röntgenstrahlung benutzenden Mammographie-Appart.

## Claims

1. A radiation imaging device (8) comprising:
- planar detection means (2a-2f) able to transform the radiation into electric charges and having an input face for receiving the radiation and an output face opposite to the input face, the input face having a common electrode (12) and the output face supporting a mosaic of point electrodes (14) for collecting the electric charges,
- means (10a-10d) for collecting the electric charges collected by the point electrodes (14), having a planar face provided with contact elements (19) and positioned facing the output face of the detection means, each electric contact element (19) facing a corresponding point electrode (14) and being connected to said point electrode by a hybridization procedure,
characterized in that:
- the detection means are constituted by a detector or several detectors (2a-2f) joined edge to edge,
- the means for collecting the electric charges are constituted by integ-rated circuit chips (10a-10d) joined edge to edge, each chip having a mosaic of reading circuits (16), an addressing circuit (18) connected to the reading circuits of the chip, each electric contact element (19) being connected to a corresponding reading circuit (16),
- metal bands (30a-30d) are provided on the planar face of the integrated circuit chips to ensure electrical connections between the reading and addressing circuits and external circuits for the supply, control and processing of output signals delivered by the integrated circuits,
- metal bands (34a-34e) being distributed on the output face of the detector or detectors (2a-2f) without electrical contact with the point electrodes (14),
- the metal bands (30a-30d) of the integrated circuit chips being positioned facing the metal bands of the detector or detectors, the continuity of each electrical connection being ensured by means of microspheres (36) connecting in hybrid manner the metal bands (30a-30d) corresponding to said connection and located on the planar face of the chips (10a-10d) to the metal bands (34a-34e) corresponding to said connection and located on the output face of the detector or detectors (2a-2f).

2. Device according to claim 1, characterized in that an electrical insulation layer (42) separates each metal band (34a) on the output face of the detection means (2a) of adjacent point electrodes (14).

3. Device according to one of the claims 1 or 2, characterized in that the detector or detectors for transforming the radiation into electric charges are made from a solid semiconductor material (6).

4. Device according to claim 2, characterized in that a metallization band (48) serving as a shield between the said metal bands (34a) and the point electrodes (14) is interposed between the electrical insulation layer (42) and the metal bands (34) and is insulated by an insulant (50) from the metal bands (34).

5. Device according to any one of the preceding claims, characterized in that it has several detectors (2a-2f) joined side by side and arranged in the form of rows and columns of a first matrix, which are interconnected by electrical connections, and several integrated circuit chips (10a-10d) joined side by side and arranged in the form of the rows and columns of a second matrix facing the first and interconnected by electrical connections.

6. Device according to any one of the claims 1 to 5, characterized in that the dimensions of the chips are the same as those of the detector or detectors.

7. Device according to claim 5 or 6, characterized in that the integrated circuit chips (10ᵢ) are displaced so as to partly face at least two consecutive detectors (2ᵢ, 2ᵢ₊₁).

8. Device according to claim 7, characterized in that the electrical connection between two consecutive chips is ensured by a metal band (34e, 34i) formed on the detector partly facing its two consecutive chips and by microspheres (36) connecting the metal bands (30a-30d) of the chips to the metal band (34e, 34i) of the detector.

9. Device according to claim 7 or 8, characterized in that the electrical connection between the metal bands (34a-d, 34i) of two consecutive detectors is ensured by a metal band (30a-30d, 30i) formed on the integrated circuit chip partly facing said two consecutive detectors and by microspheres (36).

10. Device according to claim 7, characterized in that it has n chips (10₁-10₄) on the same row of the second matrix and n metal bands (30ᵢ) specific to the planar face of each chip and numbered 1 to n for carrying to a same side of the device the specific output signals (Vₒᵤₜ) of said n chips, said metal bands having, with respect to the same side of the device, an input and an output, the output end of the ith metal band of a given chip being connected to the input end of the (i+1)th metal band of the following chip, with 1 ≤i≤ n, i and n being integers with n ≥ 2, by means of a supplementary metal band (34₁-34₄) provided on the output face of the detector (21-24) positioned facing said chips and by means of microspheres ensuring a hybrid connection between the specific metal band of the chip and the supplementary metal band of the detector, the first metal band of a given chip delivering the specific output signal of said chip.

11. Device according to claim 3, characterized in that the semiconductor has an average atomic number exceeding 30.

12. Device according to claim 3, characterized in that the semiconductor is chosen from among silicon, gallium arsenide, cadmium telluride or mercuric iodide with high resistivity.

13. Application of the imaging device according to any one of the claims 1 to 12, to an intra-buccal dental imaging device using X-radiation.

14. Application of the imaging device according to any one of the claims 1 to 12 to a mammography apparatus using X-radiation.
